# EUROPÄISCHE PATENTSCHRIFT

(11) **EP 1 166 889 B1**
(45) Veröffentlichungstag und Bekanntmachung des Hinweises auf die Patenterteilung: **18.04.2007**
(21) Anmeldenummer: 01111985.6
(22) Anmeldetag: 22.05.2001
(51) Int. Cl.: B05C 1/08, B05C 11/04

(54) **Auftragsvorrichtung zum Aufbringen von Flüssigkeiten auf plattenförmige Werkstücke**
Coating device for applying a liquid on panel-shaped work pieces
Dispositif d'enduction pour appliquer un produit liquide sur des objets sous forme de plaque

(30) Priorität: 27.06.2000 DE 10030310
(43) Veröffentlichungstag der Anmeldung: 02.01.2002
(73) Patentinhaber: Robert Bürkle GmbH, 72250 Freudenstadt (DE)
(72) Erfinder: Mai, Josef, 72160 Horb-Rexingen (DE)
(74) Vertreter: Kaiser, Magnus

(56) Entgegenhaltungen:
- CH-A- 494 071
- DE-A- 3 834 287
- US-A- 3 169 082
- US-A- 4 316 755

## Beschreibung

Die Erfindung betrifft eine Auftragsvorrichtung zum Aufbringen von Flüssigkeiten, insbesondere Lack, auf plattenförmige Werkstücke nach dem Oberbegriff des beigefügten Patentanspruchs 1.

Solche Auftragsvorrichtungen werden beispielsweise dazu verwendet, Fotoresistlack auf Leiterplatten aufzubringen. Hierbei gibt es sehr hohe Anforderungen an die Genauigkeit, da der Lack typischerweise mit einer gleichmäßigen Schichtdicke von nur 8 bis 14 Mikrometern aufgetragen werden muss.

Aus der EP 0 427 045 A1 ist eine Auftragsvorrichtung der eingangs genannten Art bekannt geworden, die eine auf den plattenförmigen Werkstücken abrollende Auftragswalze und eine zur Ausbildung eines Spalts an die Mantelfläche der Auftragswalze anstellbare Dosierwalze umfasst. In den Spalt wird der aufzutragende Lack eingebracht, von wo er von der Mantelfläche der Auftragswalze zum plattenförmigen Werkstück transportiert wird. Die Kraft, mit der die Dosierwalze an die Auftragswalze angepresst wird, wirkt sich in der Lackmenge aus, die von der Auftragswalze aus dem Spalt mitgenommen wird.

Problematisch ist bei einer solchen bekannten Auftragsvorrichtung die stirnseitige Abdichtung des Spalts, in dem die aufzutragende Flüssigkeit vorgehalten wird: Dies wurde bisher mit zwei Abdichtbacken durchgeführt, die den Spalt stirnseitig überdecken und an den Stirnseiten der Auftragswalze sowie der Dosierwalze anliegen. Um eine ausreichende Dichtheit zu gewährleisten, müssen solche Abdichtbacken gegen die Stirnseiten der Auftragswalze und der Dosierwalze gepresst werden. Dies wiederum resultiert in Reibungskräften, die bei den oben beschriebenen Genauigkeitsanforderungen beim Auftrag von Fotoresistlack auf Leiterplatten zu Ungenauigkeiten und Fehlfunktionen führen kann. Insbesondere das notwendige schlupffreie Abrollen der Dosierwalze auf der Auftragswalze kann durch eine angepresste Abdichtbacke beeinträchtigt werden.

Die internationale Anmeldung PCT/DE 97/01414 zeigt eine andere Ausführung einer eingangs genannten Auftragsvorrichtung, bei der zwar das prinzipielle Problem der stirnseitigen Abdichtung des Spalts weiter besteht, aber durch Ersetzen der Dosierwalze durch eine als Dosiereinrichtung fungierende Rakel etwas entschärft wurde.

Ausgehend von diesem Stand der Technik liegt der Erfindung die Aufgabe zugrunde, eine Auftragsvorrichtung der eingangs genannten Art hinsichtlich der stirnseitigen Abdichtung des Spalts zwischen Auftragswalze und Dosiereinrichtung weiter zu verbessern.

Gelöst ist diese Aufgabe durch eine Auftragsvorrichtung mit den Merkmalen des beigefügten Patentanspruchs 1.

Bevorzugte Ausgestaltungen und Weiterbildungen der Erfindung sind in den Patentansprüchen 2 bis 11 niedergelegt.

Die Auftragsvorrichtung nach der Erfindung umfasst also eine Auftragswalze, die auf den plattenförmigen Werkstücken abrollt, und eine als Dosiereinrichtung fungierende Rakel, wobei zwischen der Rakel und der Auftragswalze ein Spalt gebildet wird, aus dem die Auftragswalze die Flüssigkeit zum plattenförmigen Werkstück transportiert, sowie mindestens eine an einer Stirnseite der Auftragswalze anliegende, den Spalt stirnseitig überdeckende Abdichtbacke. An der mit einer Abdichtbacke versehenen Seite der Auftragswalze ist die Rakel erfindungsgemäß über die Stirnseitenebene der Auftragswalze axial überstehend ausgebildet, wobei sie dort mit einer Nut zur Aufnahme der Abdichtbacke versehen ist.

Die erfindungsgemäß vorgesehene Nut kann zur Halterung und Führung der Abdichtbacke dienen, so dass ein Anpressen dieser Abdichtbacke gegen die Stirnseite der Auftragswalze nicht weiter notwendig ist. Flüssigkeit, die aus dem Spalt wegen eines etwa zu geringen Anpressdrucks der Abdichtbacke an der Stirnseite der Auftragswalze ausfließt, wird von der Stirnseite der Auftragswalze mitgenommen und kann außerhalb des unmittelbaren Auftragsbereichs von dort abgestreift werden. Insbesondere bei Lacken ist dies wegen deren hohen Adhäsionsfähigkeit problemlos möglich.

Ferner verhindert die Nut, dass stirnseitig aus dem Spalt an der Abdichtbacke vorbei austretende Flüssigkeit nicht entlang der Rakelunterseite aus dem Randbereich der Auftragswalze in deren mittleren Bereich gelangt, wo sie von der Rakel abtropfen kann und infolgedessen die zu beschichtenden plattenförmigen Werkstücke sowie die Transporteinrichtungen verschmutzt: Auch solche Leckage-Flüssigkeit wird wegen der Nut auf die Stirnseite der Auftragswalze geleitet.

Die Halterung und Führung der Abdichtbacke in der Nut der Rakel kann dadurch optimiert werden, dass die Nut zur Stirnseitenebene der Auftragswalze hin tiefer wird, so dass eine Anstellbewegung der Rakel die Abdichtbacke seitlich zur Stirnseite der Auftragswalze hin verschiebt und daraus ein gewisser Anpressdruck resultiert.

Besondere Vorteile ergeben sich, wenn die Nut derart rinnenartig geformt ist, dass sie Flüssigkeit, die entlang der Abdichtbacke stirnseitig aus dem Spalt austritt, zur Stirnseite der Auftragswalze hin leitet, und wenn die Abdichtbacke ihrerseits eine - in Rotationsrichtung der Auftragswalze gesehen - oberhalb des Spalts angeordnete, der Stirnseite der Auftragswalze zugeordnete Abstreifeinrichtung zum Rückführen der auf der Stirnseite der Auftragswalze mitgeführten Flüssigkeit in den Spalt aufweist. Leckage-Flüssigkeit wird auf diese Art und Weise von der Auftragswalze stirnseitig etwa eine Umdrehung mitgenommen und kurz vor Erreichen des Spalts von der Abstreifeinrichtung an der Abdichtbacke in den Spalt zurück zwangsgeführt. Soweit die Adhäsionskraft der verwendeten Flüssigkeit genügend hoch ist, ist nur noch eine sehr geringe bis gar keine Anpresskraft zwischen der Abdichtbacke und der Stirnseite der Auftragswalze nötig, da Leckage-Flüssigkeit nicht abtropfen kann, sondern in jedem Fall in den Spalt rückgeführt wird. Nachteilige Reibungskräfte, die durch ein Anpressen der Abdichtbacke resultieren und die Präzision des Flüssigkeitsauftrags stören, können hierdurch nahezu vollständig eliminiert werden.

Die Abstreifeinrichtung kann so ausgebildet sein, dass die Begrenzung der auf der Stirnseite der Auftragswalze anliegenden Fläche der Abdichtbacke eine Kontaktlinie bildet, die sich mit zunehmendem radialen Abstand von der Achse der Auftragswalze zunehmend von einer durch diese Achse gelegten Gerade entfernt. Flüssigkeit, die an der Stirnseite der Auftragswalze anhaftet und gegen diese Kontaktlinie aufläuft, wird aufgrund deren Verlauf von der Mitte der Auftragswalzenstirnseite zu ihrem Umfang hin gefördert, infolgedessen zwangsweise auf die Mantelfläche der Auftragswalze geführt und von dieser in den Spalt mitgenommen. Um zu verhindern, dass die auf diese Kontaktlinie auflaufende Flüssigkeit axial nach außen fließen kann, wird die Abdichtbacke zweckmäßigerweise abgeschrägt, um vor der Kontaktlinie eine Trichterfläche zu bilden.

Zum Anstellen an die Auftragswalze und zum Verändern der Spaltbreite kann die Rakel exzentrisch schwenkbar befestigt sein. Die exakte Parallelität der Auftragswalze und der Rakelkante kann insofern nicht mehr durch eine ungleichmäßig arbeitende Anstellmechanik gefährdet werden: Wenn die Achse der Auftragswalze und die Schwenkachse der Rakel stabil genug befestigt sind, kann eine schwenkende Anstellbewegung der Rakel zwangsläufig nur zu einem exakt parallelen Spalt führen.

Um das Einjustieren der Spaltbreite möglichst genau durchführen zu können, ist es vorteilhaft, wenn die Rakelkante konvex geformt ist. Hierdurch ergibt sich eine Art Übersetzung der Schwenkbewegung in eine Veränderung der Spaltbreite.

Die Abdichtbacke ist vorzugsweise an der Schwenkachse der Rakel aufgehängt und somit unabhängig von der Schwenkbewegung der Rakel.

Da die Parallelität der Rakel durch die schwenkende Anstellbewegung in jedem Fall gewährleistet ist, kann ein Federelement, beispielsweise ein pneumatisch betätigbarer Balgzylinder, für die Anstellbewegung vorgesehen sein.

Schließlich ist die Rakel vorzugsweise mit einem Kanal zur Zuführung der aufzutragenden Flüssigkeit sowie mit einer Anzahl von aus diesem Kanal führenden, oberhalb des Spalts angeordneten Austrittsöffnungen versehen. Zweckmäßigerweise ist der Kanal innerhalb der Schwenkachse der Rakel angeordnet.

Ein Ausführungsbeispiel der Erfindung wird im folgenden anhand der beigefügten Zeichnungen näher beschrieben und erläutert. Es zeigen:
- Figur 1: eine Seitenansicht der Hauptbestandteile einer erfindungsgemäßen Auftragsvorrichtung;
- Figur 2: eine Draufsicht auf die Auftragsvorrichtung aus Figur 1;
- Figur 3: eine Ansicht aus Richtung X gemäß Figur 1;
- Figur 4: eine Ansicht aus Richtung Y gemäß Figur 1;
- Figur 5: eine teilgeschnittene Seitenansicht entlang A-A gemäß Figur 2.

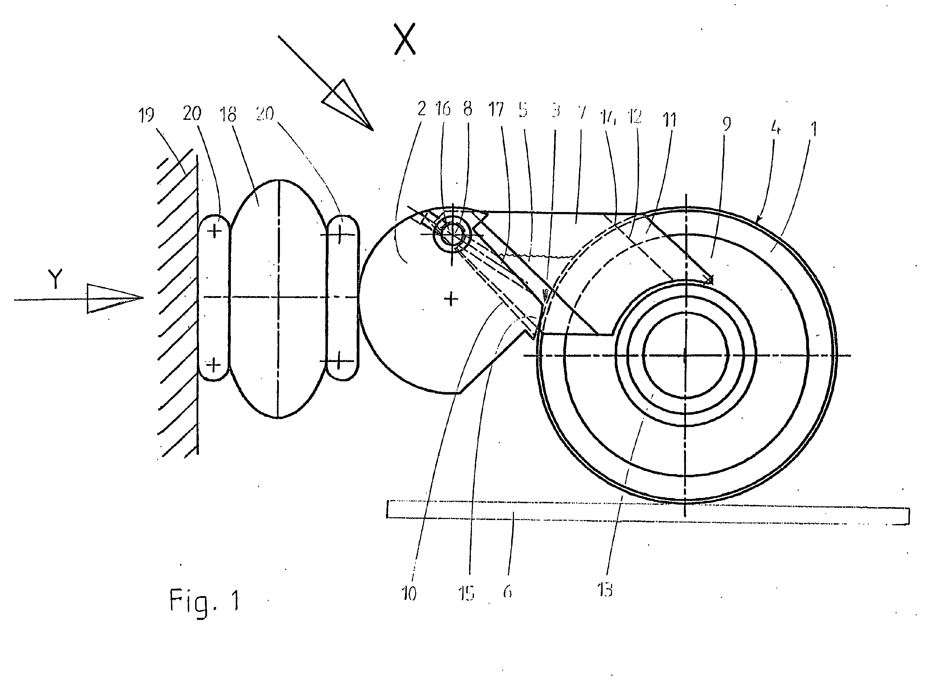

Figur 1 zeigt die Hauptbestandteile einer erfindungsgemäßen Auftragsvorrichtung in einer Seitenansicht. Erkennbar sind eine Auftragswalze 1 und eine Rakel 2, die an die Auftragswalze 1 zur Bildung eines Spalts 3 angestellt ist. Die Mantelfläche 4 der Auftragswalze 1 nimmt aus diesem Spalt 3 Flüssigkeit 5 mit und transportiert sie zu einem plattenförmigen Werkstück 6, um die Flüssigkeit 5 dort aufzutragen. Stirnseitig ist der Spalt 3 mit einer Abdichtbacke 7 abgedeckt, die an der Schwenkachse 8 der exzentrisch schwenkbar befestigten Rakel 2 aufgehängt ist und an der Stirnseite 9 der Auftragswalze 1 anliegt. Die Rakel 2 steht aus der Bildebene vorspringend über die Abdichtbacke 7 hinaus und nimmt diese in einer mit durchbrochenen Linien dargestellten Nut 10 auf. Diese Nut 10 ist derart geformt, dass die Abdichtbacke 7 darin gehaltert und geführt ist. Außerdem wird Flüssigkeit 5, die aufgrund eines etwa zu geringen Anpressdrucks der Abdichtbacke 7 gegen die Stirnseite 9 der Auftragswalze 1 entlang der Abdichtbacke 7 aus dem Spalt 3 hinausläuft, innerhalb der Nut 10 derart geführt, dass sie auf die Stirnseite 9 der Auftragswalze 1 geleitet wird. Dort wird die Flüssigkeit 5 an der Stirnseite 9 anhaftend mitgenommen und gerät nach einer Rotation um etwa 270 Winkelgrade in eine abgeschrägte Trichterfläche 11 der Abdichtbacke 7. Die Trichterfläche 11 nähert sich in Rotationsrichtung der Auftragswalze 1 der Stirnseite 9 bis zu einer Kontaktlinie 12 immer mehr an, so dass die auf der Stirnseite 9 anhaftende Flüssigkeit 5 entlang der Kontaktfläche 12, die sich mit zunehmendem Abstand von der Achse 13 der Auftragswalze 1 von einer exakt radialen Geraden zunehmend entfernt, bis zum Schnittpunkt 14 der Kontaktlinie 12 mit der Mantelfläche 4 zwangsweise transportiert wird. Am Schnittpunkt 14 gelangt die Leckage-Flüssigkeit auf die Mantelfläche 4 und wird von dieser wieder in den Spalt 3 zurückgeführt.

Zur besseren Einstellbarkeit der Spaltbreite ist die Rakelkante 15 der Rakel 2 konvex geformt, so dass die Schwenkbewegung der Rakel 2 um die Schwenkachse 8 in eine ungleich kleinere Veränderungsbewegung des Spaltabstands übersetzt wird. Die Schwenkachse 8 der Rakel 2 ist mit einem Kanal 16 zur Zuführung der Flüssigkeit 5 versehen, wobei der Kanal mit oberhalb des Spalts 3 mündenden Austrittsöffnungen 17 verbunden ist.

Auf der Rückseite der Rakel 2 ist zur Erzeugung der Anstellbewegung ein Balgzylinder 18 vorgesehen, der an einem Rahmen 19 gehaltert und von zwei Puffern 20 umgeben ist.

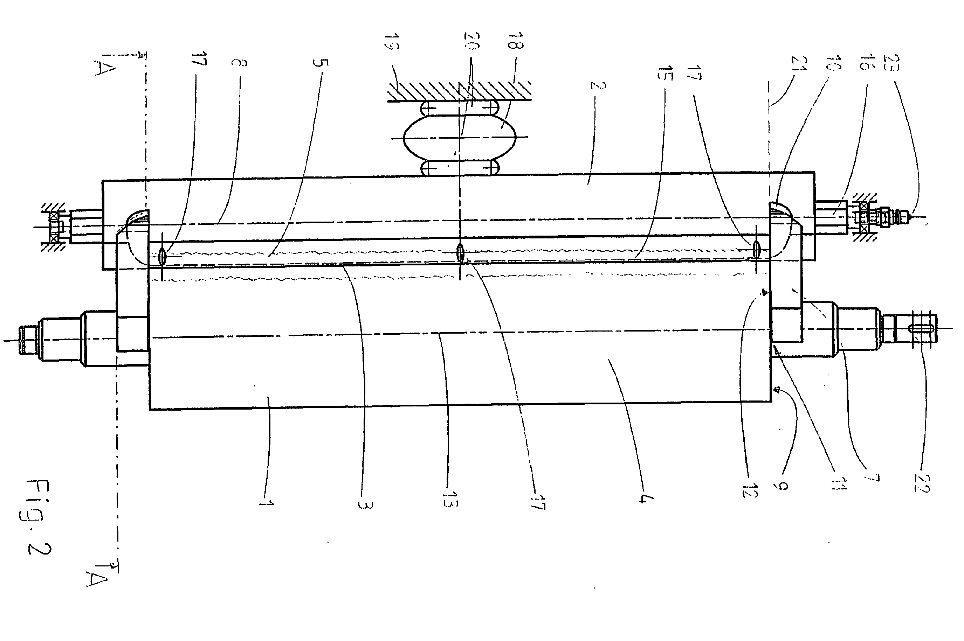

Figur 2 verdeutlicht in einer Draufsicht die Funktionsweise des dargestellten Ausführungsbeispiels weiter: Die Nut 10 und deren Formung, durch die die Leckage-Flüssigkeit zur Stirnseite 9 der Auftragswalze hingeleitet wird, ist hier deutlich zu erkennen. Ebenso wird verdeutlicht, wie an der Stirnseite 9 anhaftende Leckage-Flüssigkeit über die Trichterfläche 11" eingefangen" und an der Kontaktlinie 12 auf die Mantelfläche 4 der Auftragswalze 1 zurückgeführt wird. Außer den anhand der Figur 1 beschriebenen Teilen, die hier mit identischen Bezugszeichen versehen sind, ist eine Stirnseitenebene 21 der Auftragswalze 1 eingezeichnet, um zu verdeutlichen, dass die Rakel 2 stirnseitig über die Auftragswalze 1 axial überstehend ausgebildet ist. Schließlich sind noch eine Antriebswelle 22 für die Auftragswalze 1 und ein Flüssigkeitszulauf 23, der sich in den Kanal 16 fortsetzt, dargestellt.

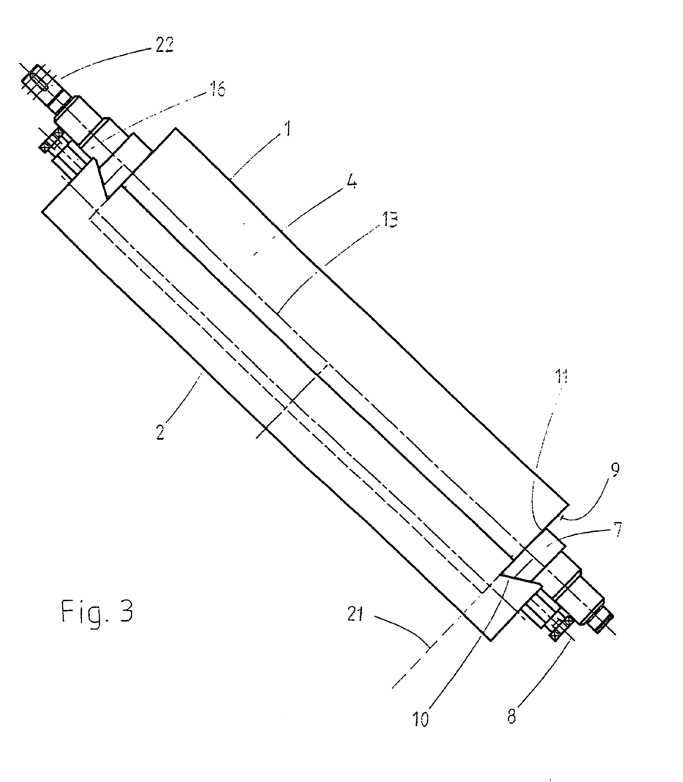

Figur 3 zeigt das Ausführungsbeispiel aus Figur 1 in einer Ansicht aus Richtung X. In dieser Ansicht wird die schwimmende Lagerung der Abdichtbacke 7 in der sich zur Stirnseitenebene 21 hin vertiefenden Nut 10 besonders deutlich. Eine Anstellbewegung der Rakel 2 führt hierdurch zu einer Bewegung der Abdichtbacke 7 zur Stirnseite 9 der Auftragswalze 1 hin. Der Balgzylinder 18 ist der besseren Verständlichkeit wegen hier weggelassen worden.

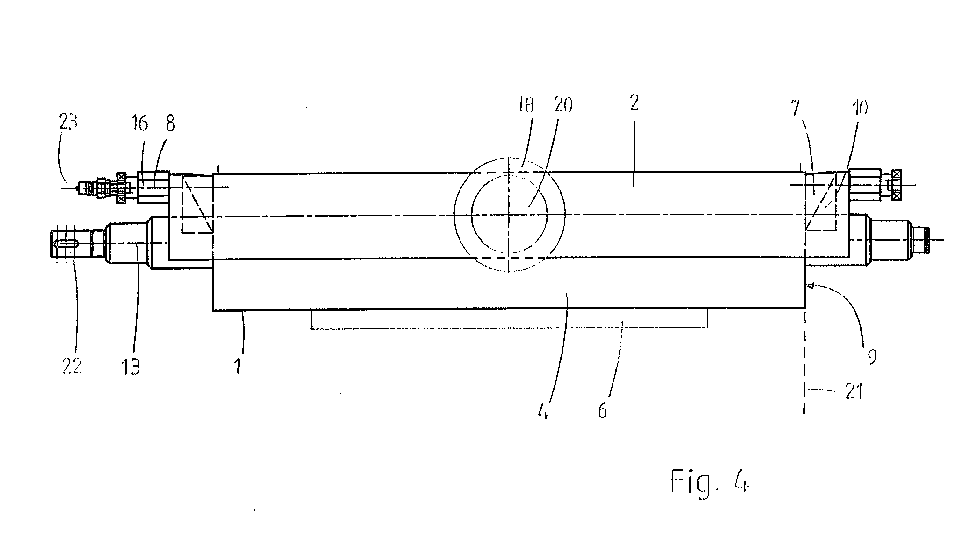

Figur 4 zeigt eine Ansicht aus Richtung Y gemäß Figur 1. Die Abdichtbacke 7 und die Nut 10 sind in dieser Darstellung eigentlich nicht sichtbar, weshalb sie mit durchbrochenen Linien angedeutet sind. Erkennbar ist hier wieder die angeschrägte Ausbildung der Nut 10 und der korrespondierende Teil der Abdichtbacke 7, der einerseits zu einer schwimmenden Lagerung der Abdichtbacke 7 führt und andererseits gewährleistet, dass Leckage-Flüssigkeit ausschließlich auf die Stirnseite 9 der Auftragswalze 1 geleitet wird, also weder abtropft noch entlang der Rakel 2 in den Bereich der plattenförmigen Werkstücke 6 oder der Transporteinrichtung gelangt.

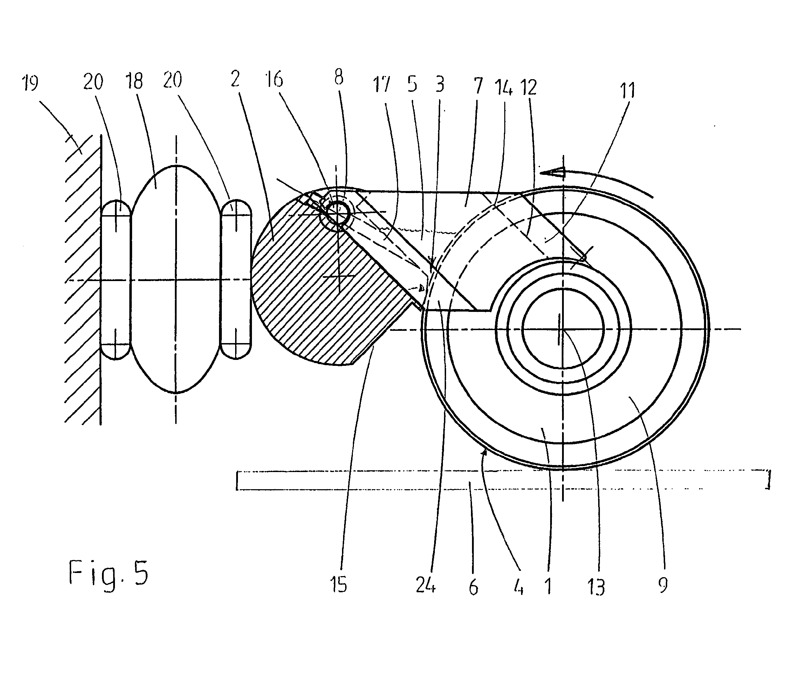

Figur 5 schließlich verdeutlicht nochmals in einer ähnlichen Darstellung wie Figur 1 die Ausbildung der Abdichtbacke 7 und der Nut 10. Korrespondierend mit dem angeschrägten Nutengrund weist die Abdichtbacke 7 eine Anschrägung 24 auf, wodurch mit der durch den Balgzylinder 18 hervorgerufenen Anstellbewegung der Rakel 2 ein gewisser, wohldefinierter Anpressdruck der Abdichtbacke 7 an die Stirnseite 9 der Auftragswalze 1 hervorgerufen wird. Im übrigen kann vollinhaltlich auf die Beschreibung der Figur 1 verwiesen werden.

### Bezugszeichenliste

- 1.: Auftragswalze
- 2.: Rakel
- 3.: Spalt
- 4.: Mantelfläche (von 1.)
- 5.: Flüssigkeit
- 6.: Werkstück
- 7.: Abdichtbacke
- 8.: Schwenkachse
- 9.: Stirnseite (von 1.)
- 10.: Nut
- 11.: Trichterfläche
- 12.: Kontaktlinie
- 13.: Achse (von 1.)
- 14.: Schnittpunkt
- 15.: Rakelkante
- 16.: Kanal
- 17.: Austrittsöffnung
- 18.: Balgzylinder
- 19.: Rahmen
- 20.: Puffer
- 21.: Stirnseitenebene
- 22.: Antriebswelle
- 23.: Flüssigkeitszulauf
- 24.: Anschrägung

## Patentansprüche

1. Auftragsvorrichtung zum Aufbringen von Flüssigkeiten, insbesondere Lack, auf plattenförmige Werkstücke, mit einer auf den plattenförmigen Werkstücken (6) abrollenden Auftragswalze (1) und einer zur Ausbildung eines Spalts (3) an die Mantelfläche (4) der Auftragswalze (1) anstellbaren Dosiereinrichtung, wobei die Flüssigkeit (5) auf der Mantelfläche (4) der Auftragswalze (1) vom Spalt (3) zum plattenförmigen Werkstück (6) transportierbar ist, und mit mindestens einer an einer Stirnseite (9) der Auftragswalze (1) anliegenden, den Spalt (3) stirnseitig überdeckenden Abdichtbacke (7),
**dadurch gekennzeichnet,**
**dass** die Dosiereinrichtung als Rakel (2) ausgebildet ist, die im Bereich der Abdichtbacke (7) axial über die Stirnseitenebene (21) der Auftragswalze (1) übersteht und eine Nut (10) zur Aufnahme der Abdichtbacke (7) aufweist.

2. Auftragsvorrichtung nach Anspruch 1,
**dadurch gekennzeichnet,**
**dass** sich die Nut zur Stirnseitenebene (21) der Auftragswalze (1) hin vertieft.

3. Auftragsvorrichtung nach einem der Ansprüche 1 oder 2,
**dadurch gekennzeichnet,**
**dass** die Nut (10) derart rinnenartig geformt ist, dass sie Flüssigkeit (5), die an der Abdichtbacke (7) stirnseitig aus dem Spalt (3) austritt, zur Stirnseite (9) der Auftragswalze (1) hin leitet, und dass die Abdichtbacke (7) eine oberhalb des Spalts (3) angeordnete, der Stirnseite (9) der Auftragswalze (1) zugeordnete Abstreifeinrichtung zum Rückführen von auf der Stirnseite (9) der Auftragswalze (1) mitgeführter Flüssigkeit (5) in den Spalt (3) aufweist.

4. Auftragsvorrichtung nach Anspruch 3,
**dadurch gekennzeichnet,**
**dass** die Abstreifeinrichtung durch die Begrenzung der auf der Stirnseite (9) der Auftragswalze (1) anliegenden Fläche der Abdichtbacke (7) gebildet ist, welche Begrenzung eine Kontaktlinie (12) bildet, die sich mit zunehmendem radialen Abstand von der Achse (13) der Auftragswalze (1) zunehmend von einer durch diese Achse (13) gelegten Gerade entfernt.

5. Auftragsvorrichtung nach Anspruch 4,
**dadurch gekennzeichnet,**
**dass** die Abdichtbacke (7) zur Bildung einer Trichterfläche (11) vor der Kontaktlinie (12) abgeschrägt ist.

6. Auftragsvorrichtung nach einem der Ansprüche 1 bis 5,
**dadurch gekennzeichnet,**
**dass** die Rakel (2) zum Anstellen an die Auftragswalze (1) und zum Verändern der Spaltbreite exzentrisch schwenkbar befestigt ist.

7. Auftragsvorrichtung nach Anspruch 6,
**dadurch gekennzeichnet,**
**dass** die Rakelkante (15) konvex geformt ist.

8. Auftragsvorrichtung nach einem der Ansprüche 6 oder 7,
**dadurch gekennzeichnet,**
**dass** die Abdichtbacke (7) an der Schwenkachse (8) der Rakel (2) aufgehängt ist.

9. Auftragsvorrichtung nach einem der Ansprüche 6 bis 8,
**dadurch gekennzeichnet,**
**dass** die Rakel (2) mittels eines Federelements an die Auftragswalze (1) anstellbar ist.

10. Auftragsvorrichtung nach Anspruch 9,
**dadurch gekennzeichnet,**
**dass** das Federelement aus mindestens einem pneumatisch betätigbaren Balgzylinder (18) gebildet ist.

11. Auftragsvorrichtung nach einem der Ansprüche 1 bis 10,
**dadurch gekennzeichnet,**
**dass** die Rakel (2) mit einem Kanal (16) und einer Anzahl von diesem Kanal (16) zugeordneten, oberhalb des Spalts (3) mündenden Austrittsöffnungen (17) versehen ist.

## Claims

1. A coating device for the application of liquids, especially paint, onto plate-shaped workpieces, with an application roller (1) that rolls on the plate-shaped workpiece (6) and a metering device that can be placed against the surface area (4) of the application roller (1) to create a gap (3), whereby the liquid (5) can be transported from the gap (3) on the mantle area (4) of the application roller (1) onto the plate-shaped work piece (6), and with at least one sealing shoe (7) that covers the front side of the gap (3) and lies against front side (9) of the application roller (1),
**characterised in that**
the metering device is built as a doctor blade (2), which projects axially over the frontal plane (21) of the application roller (1) in the area of the sealing shoe (7) and has a groove (10) to accept the sealing shoe (7).

2. A coating device according to claim 1,
**characterised in that**
the groove deepens toward the frontal plane (21) of the applicator roller (1).

3. A coating device according to one of claims 1 or 2,
**characterised in that**
the groove (10) is formed in a channel-like manner, so that the liquid (5) that exits from the gap (3) on the front side of the sealing shoe (7), is conducted towards the front side (9) of the application roller (1), and that the sealing shoe (7) has a wiping device arranged above the gap (3) and associated with the front face (9) of the application roller (1) to return of fluid (5) carried along on the face (9) of the application roller (1) into the gap (3).

4. A coating device according to claim 3,
**characterised in that**
the wiping device is formed through the boundary of surface of the sealing shoe (7) lying on the front side (9) of the application roller (1), which boundary forms a contact line (12) that, with increasing radial distance from the axle (13) of the application roller (1), is increasingly distant from a straight line lying through this axle (13).

5. A coating device according to claim 4,
**characterised in that**
the sealing shoe (7) is oblique, to form a funnel surface (11) in front of the contact line (12).

6. A coating apparatus according to one of claims 1 to 5,
**characterised in that**
the doctor blade (2) is attached eccentrically so as to pivot, for placement against the application roller (1) and to vary the width of the gap.

7. A coating apparatus according to claim 6,
**characterised in that**
the edge (15) of the doctor blade is convex-shaped.

8. A coating apparatus according to one of claims 6 or 7,
**characterised in that**
the sealing shoe (7) is suspended from the pivot axis (8) of the doctor blade (2).

9. A coating apparatus according to one of claims 6 through 8, **characterised in that**
the doctor blade (2) can be placed against the application roller (1) means of a spring element.

10. A coating device according to claim 9,
**characterised in that**
the spring element is formed from at least bellows cylinder (18) that can be activated pneumatically.

11. A coating device according to one of claims 1 through 10,
**characterised in that**
the doctor blade (2) is provided with a channel (16) and several exit openings (17) associated with the channel (16) that discharges above the gap (3).

## Revendications

1. Dispositif d'enduction pour déposer des fluides, notamment de la laque, sur des pièces en forme de plaques, comprenant un cylindre applicateur (1) roulant sur les pièces (6) en forme de plaques ; un système doseur pouvant être présenté à la surface (4) de l'enveloppe dudit cylindre applicateur (1), en vue de réserver un interstice (3), sachant que le fluide (5) peut être convoyé, sur la surface (4) de l'enveloppe du cylindre applicateur (1), depuis l'interstice (3) jusqu'à la pièce (6) en forme de plaque ; et au moins une coquille d'étanchement (7) portant contre une face extrême (9) du cylindre applicateur (1), et recouvrant frontalement l'interstice (3),
**caractérisé par le fait**
**que** le système doseur est réalisé sous la forme d'une racle (2) qui fait saillie axialement, dans la région de la coquille d'étanchement (7), au-delà du plan (21) de la face extrême du cylindre applicateur (1), et comporte une rainure (10) de réception de ladite coquille d'étanchement (7).

2. Dispositif d'enduction selon la revendication 1,
**caractérisé par le fait**
**que** la rainure devient plus profonde en direction du plan (21) de la face extrême du cylindre applicateur (1).

3. Dispositif d'enduction selon l'une des revendications 1 ou 2,
**caractérisé par le fait**
**que** la rainure (10) est configurée en une rigole, de telle sorte qu'elle dirige, vers la face extrême (9) du cylindre applicateur (1), le fluide (5) sortant frontalement de l'interstice (3) sur la coquille d'étanchement (7) ; et par le fait que ladite coquille d'étanchement (7) est munie d'un système racleur disposé au-dessus de l'interstice (3), affecté à la face extrême (9) du cylindre applicateur (1) et conçu pour renvoyer, vers ledit interstice (3), du fluide (5) charrié conjointement sur ladite face extrême (9) dudit cylindre applicateur (1).

4. Dispositif d'enduction selon la revendication 3,
**caractérisé par le fait**
**que** le système racleur est formé par la délimitation de la surface de la coquille d'étanchement (7) qui porte contre la face extrême (9) du cylindre applicateur (1), laquelle délimitation forme une ligne de contact (12) qui, au fur et à mesure de l'accroissement de la distance radiale vis-à-vis de l'axe (13) dudit cylindre applicateur (1), s'éloigne de plus en plus d'une droite passant par cet axe (13).

5. Dispositif d'enduction selon la revendication 4,
**caractérisé par le fait**
**que** la coquille d'étanchement (7) est biseautée devant la ligne de contact (12), pour donner naissance à une surface infundibuliforme (11).

6. Dispositif d'enduction selon l'une des revendications 1 à 5,
**caractérisé par le fait**
**que** la racle (2) est fixée à pivotement excentré, en vue de la présentation au cylindre applicateur (1) et en vue de faire varier la largeur de l'interstice.

7. Dispositif d'enduction selon la revendication 6,
**caractérisé par le fait**
**que** le bord (15) de la racle est de forme convexe.

8. Dispositif d'enduction selon l'une des revendications 6 ou 7,
**caractérisé par le fait**
**que** la coquille d'étanchement (7) est suspendue à l'axe de pivotement (8) de la racle (2).

9. Dispositif d'enduction selon l'une des revendications 6 à 8,
**caractérisé par le fait**
**que** la racle (2) peut être présentée au cylindre applicateur (1) au moyen d'un élément élastique.

10. Dispositif d'enduction selon la revendication 9,
**caractérisé par le fait**
**que** l'élément élastique est constitué d'au moins un vérin à soufflet (18), actionnable pneumatiquement.

11. Dispositif d'enduction selon l'une des revendications 1 à 10,
**caractérisé par le fait**
**que** la racle (2) est munie d'un canal (16) et d'un certain nombre d'orifices de sortie (17) affectés à ce canal (16), et débouchant au-dessus de l'interstice (3).
